# FASCICULE DE BREVET EUROPEEN

(11) **EP 1 285 461 B1**
(45) Date de publication et mention de la délivrance du brevet: **25.01.2017**
(21) Numéro de dépôt: 01940623.0
(22) Date de dépôt: 29.05.2001
(51) Int. Cl.: H01L 21/762, H01L 21/20, H01L 21/78, H01L 21/34

(54) **PROCEDE DE FABRICATION D'UNE COUCHE MINCE**
HERSTELLUNGSVERFAHREN EINER DÜNNSCHICHT
METHOD OF MANUFACTURING A THIN FILM

(30) Priorité: 30.05.2000 FR 0006909
(43) Date de publication de la demande: 26.02.2003
(73) Titulaire: Commissariat à l'Énergie Atomique et aux Énergies Alternatives, 75015 Paris (FR)
(72) Inventeur: ASPAR, Bernard, F-38140 Rives (FR); LAGAHE, Chrystelle, F-38340 Voreppe (FR); RAYSSAC, Olivier, F-38000 Grenoble (FR); GHYSELEN, Bruno, F-38170 Seyssinet (FR)
(74) Mandataire: Ilgart, Jean-Christophe
(86) Numéro de dépôt international: PCT/FR2001/001659
(87) Numéro de publication internationale: WO 2001/093325

(56) Documents cités:
- WO-A-00/19499
- FR-A- 2 748 851
- FR-A- 2 773 261
- FR-A- 2 774 511
- US-A- 5 198 371
- US-A- 5 877 070
- TONG ET AL: "A smarter-cut to low temperature silicon transfer layer" APPLIED PHYSICS LETTERS, AMERICAN INSTITUTE OF PHYSICS. NEW YORK, US, vol. 72, no. 1, 5 janvier 1998 (1998-01-05), pages 49-51, XP002128655 ISSN: 0003-6951
- SOM T ET AL: "Diffusion study of plasma ion implanted H in silicon" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, vol. 161-163, mars 2000 (2000-03), pages 677-681, XP004192309 ISSN: 0168-583X

## Description

### Domaine technique

La présente invention concerne un procédé d'obtention d'une couche mince. Elle concerne encore un procédé d'obtention d'une structure de type semiconducteur sur isolant.

L'invention s'applique en particulier à la microélectronique et au domaine des semiconducteurs.

### Etat de la technique antérieure

L'introduction d'espèces gazeuses dans un matériau solide peut être avantageusement réalisée par implantation ionique. Ainsi, le document FR-A-2 681 472 (correspondant au brevet américain N° 5 374 564) décrit un procédé de fabrication de films minces de matériau semiconducteur. Ce document divulgue que l'implantation d'un gaz rare ou d'hydrogène dans un substrat en matériau semiconducteur est susceptible d'induire, dans certaines conditions, la formation de microcavités ou de microbulles (encore désignées par le terme "platelets" dans la terminologie anglo-saxonne) à une profondeur voisine de la profondeur moyenne de pénétration des ions implantés. Si ce substrat est mis en contact intime, par sa face implantée avec un raidisseur et qu'un traitement thermique est appliqué à une température suffisante, il se produit une interaction entre les microcavités ou les microbulles conduisant à une séparation du substrat semiconducteur en deux parties : un film mince semiconducteur adhérant au raidisseur d'une part, le reste du substrat semiconducteur d'autre part. La séparation a lieu au niveau de la zone où les microcavités ou microbulles sont présentes. Le traitement thermique est tel que l'interaction entre les microbulles ou microcavités créées par implantation est apte à induire une séparation entre le film mince et le reste du substrat. On peut donc obtenir le transfert d'un film mince depuis un substrat initial jusqu'à un raidisseur servant de support à ce film mince.

Ce procédé peut également s'appliquer à la fabrication d'un film mince de matériau solide autre qu'un matériau semiconducteur, un matériau conducteur ou diélectrique, cristallin ou non.

La technique divulguée par le document FR-A-2 681 472 a donné lieu à certains perfectionnements ou développements. Ainsi, le document FR-A-2 748 851 divulgue un procédé qui permet, après une étape d'implantation ionique dans une gamme de doses appropriées et avant l'étape de séparation, de réaliser un traitement thermique de la partie de la plaquette correspondant à la future couche mince, en particulier entre 400°C et 900°C pour le silicium, sans dégrader l'état de surface de la face plane de la plaquette et sans séparation de la couche mince. Ce traitement thermique peut faire partie des opérations d'élaboration de composants électroniques ou être imposé pour d'autres raisons.

Le document FR-A-2 767 416 divulgue qu'il est possible de baisser la température de recuit si l'on tient compte du budget thermique fourni au substrat au cours des différentes étapes du procédé (étape d'implantation ionique, étape éventuelle d'adhésion du substrat sur le raidisseur, traitements intermédiaires éventuels, étape de recuit apte à permettre la séparation). Par budget thermique, on entend que, pour une étape où un apport thermique est apporté (par exemple lors de l'étape de recuit), il ne faut pas raisonner uniquement sur la température mais sur le couple temps-température fourni au substrat. De façon générale, le choix du budget thermique à utiliser pour obtenir la fracture dépend de l'ensemble des budgets thermiques appliqués au matériau de base ou à la structure à partir de l'étape d'implantation. Tous ces budgets thermiques constituent un bilan thermique qui permet d'atteindre le clivage de la structure. Ce bilan thermique est généralement formé par au moins deux budgets thermiques : celui de l'implantation et celui du recuit.

L'amélioration proposée par le document FR-A-2 773 261 est rendue possible grâce à la création dans le matériau du substrat initial d'une inclusion ou d'un ensemble d'inclusions permettant de confiner les espèces gazeuses introduites lors de l'étape d'implantation ionique. Une inclusion est un volume de matériau dont les propriétés sont différentes de celles du matériau du substrat à partir duquel on veut transférer un film mince ou des films minces. Les inclusions peuvent se présenter sous la forme d'une couche s'étendant sensiblement parallèlement à la surface au travers de laquelle on réalise l'implantation. Les formes que peuvent prendre ces volumes sont diverses et leurs dimensions peuvent aller de quelques dixièmes de nanomètres à plusieurs centaines de micromètres. Le rôle des inclusions est d'être des pièges pour les espèces gazeuses implantées. Le rayon d'action de ces pièges dépend de la nature des inclusions réalisées. Le procédé comprend une étape préliminaire consistant à former des inclusions dans le matériau du substrat initial. Une étape postérieure consiste à implanter des espèces gazeuses, de gaz rare ou non, dans ce matériau. La présence des inclusions formées à l'étape précédente entraîne un confinement des espèces gazeuses implantées. L'efficacité des inclusions est liée à leur pouvoir de confinement des espèces gazeuses.

Certains procédés divulgués par les documents cités ci-dessus permettent la réalisation, en partie ou en totalité, de composants par exemple électroniques avant la séparation au niveau de la zone implantée et le report sur un support. C'est le cas notamment du document FR-A-2 748 851.

Il est connu par ailleurs de mettre en oeuvre une implantation de protons, avec des doses de l'ordre de 3.10¹⁶H⁺/cm², pour créer une couche enterrée isolante après un traitement thermique du type RTA (pour "Rapid Thermal Annealing") ou un recuit conventionnel à haute température. On peut se reporter à ce sujet aux brevets des Etats-Unis N° 5 633 174 et 5 198 371.

Pour certaines applications, il apparaît essentiel de pouvoir réaliser des substrats comprenant une zone fragilisée. De tels substrats peuvent être appelés "substrats démontables". Ainsi, le document FR-A-2 748 851 propose un procédé permettant de créer une zone fragile enterrée à partir d'une implantation d'espèces gazeuses, comme par exemple l'hydrogène et/ou les gaz rares, introduites seules ou en combinaison. La structure ainsi obtenue (présentant une couche superficielle, une zone enterrée et un substrat) est compatible avec la réalisation partielle ou totale de composants microélectroniques, optoélectroniques ou relevant du domaine des micro-technologies. Ce procédé permet d'éviter la formation de cloques en surface lors des traitements thermiques mis en oeuvre pour la réalisation de composants électroniques. Un des moyens d'y parvenir est de contrôler la dose d'espèces gazeuses implantées. La zone fragilisée est une zone préférentielle de séparation. Si des contraintes sont judicieusement exercées sur cette zone, la séparation peut avoir lieu.

Un tel substrat démontable après la réalisation de composants électroniques peut présenter de nombreux avantages dans le domaine de la fabrication de matériaux, dans le domaine où des couches minces de matériaux contenant partiellement ou en totalité des composants électroniques sont nécessaires. Ces couches minces, constituant à leur tour des substrats, peuvent être autoportées ou reportées sur des supports qui peuvent être souples, tels que par exemple les plastiques, ou rigides, tels le verre, le silicium ou les matériaux céramiques. De tels substrats sous forme de couche mince peuvent être utilisés pour réaliser des composants photovoltaïques, des composants électroniques ou même des imageurs.

Il apparaît de plus en plus désirable de disposer de substrats démontables, c'est-à-dire présentant une couche mince séparée d'un substrat initial par une zone fragilisée, compatibles avec la mise en oeuvre d'étapes technologiques destinées à fabriquer des composants dans la couche mince et pouvant impliquer des températures élevées sans altérer l'état de la couche mince. Ces étapes impliquant des températures élevées peuvent être des étapes de réalisation, totale ou partielle, de composants électroniques si la couche mince est une couche de matériau semiconducteur.

Le document WO-A-00/19499 divulgue un procédé de transfert de couches minces de matériau monocristallin sur un substrat. Ce procédé est du type Smartcut. Il a pour objectif d'utiliser une faible dose d'hydrogène implanté et d'obtenir un clivage à basse température. Pour cela, le procédé prévoit une première étape d'implantation d'un premier substrat consistant à implanter un élément formant piège pour des ions hydrogène. Lors d'une deuxième étape d'implantation, des ions hydrogène sont implantés au même niveau que les ions de la première implantation. La troisième étape consiste en un traitement thermique à une température et pendant une durée choisie pour que les ions hydrogène soient en partie libérés de leurs pièges. Ce traitement provoque la formation et la croissance de micro-fissures remplies d'hydrogène à une profondeur proche de la profondeur de concentration maximum en hydrogène. La quatrième étape consiste à fixer le premier substrat sur un deuxième substrat. La cinquième étape est une étape de traitement thermique provoquant la libération complète des ions hydrogène de leurs pièges pour aboutir au clivage.

Le document « A smarter-cut approach to low temperature silicon layer transfert » de Q.-Y. Tong et al., Applied Physics Letters, vol. 72, N°1, 5 janvier 1998 divulgue un procédé voisin du procédé divulgué dans WO-A-00/19499. Des ions hydrogène sont implantés à une profondeur alignée sur celle d'ions bore implantés. Les ions bore jouent le rôle de piège pour les ions hydrogène. Il en résulte une température de clivage inférieure à la température qui serait nécessaire en l'absence de pièges pour les ions hydrogène.

Le document FR-A-2 774 511 divulgue un substrat compilant comprenant un support et au moins une couche mince, formée en surface dudit support et destinée à recevoir, de manière solidaire, une structure amenant des contraintes, le support et la couche mince étant reliés l'un à l'autre par une zone de liaison telle que les contraintes amenées par ladite structure sont tout ou partie absorbées par la couche mince et/ou par la zone de liaison.

Le brevet US 5 877 070 divulgue un procédé de transfert de couches minces de matériau monocristallin sur un substrat. Le procédé divulgué est une variante du procédé Smarcut.

Le document « Diffusion study of plasma ion implanted H in silicon de T. Som et al., Nuclear Instruments and Methods in Physics Research B 161-163 (2000), pages 677 à 681, traite de la diffusion thermique d'ions hydrogène implantés par un procédé plasma dans du silicium. Il divulgue que, en fonction de la température à laquelle est portée un substrat en silicium implanté, des ions hydrogène peuvent diffuser. Cependant, l'implantation n'a pas eu pour objet de produire des microbulles gazeuses.

### Exposé à l'invention

La présente invention permet de disposer de substrats démontables répondant notamment à ce souhait. L'invention a pour objet un procédé d'obtention d'une couche mince à partir d'un substrat, tel que décrit dans la revendication 1.

Selon l'invention, on évacue tout ou partie de l'espèce gazeuse de façon à éviter un effet de pression, dans les microcavités ou microfissures, qui pourrait induire une déformation de la surface (par exemple sous forme de "blisters") ou une séparation au cours des traitements thermiques auxquels ce substrat fragilisé pourrait être soumis. L'objectif d'un tel procédé est d'obtenir un substrat fragilisé en profondeur qui soit à la fois compatible avec des procédés de réalisation de composants à haute température et apte à permettre la séparation de la couche mince d'avec le reste du substrat.

Avantageusement, l'introduction d'au moins une espèce gazeuse est réalisée par implantation ionique. Cette implantation peut bien entendu être assistée par une diffusion d'espèces, telle que la diffusion activée thermiquement ou la diffusion plasma.

L'étape d'évacuation de l'espèce gazeuse comprend un traitement thermique mené de façon à permettre à tout ou partie de l'espèce gazeuse introduite de quitter les microcavités par diffusion. Cette approche est originale car habituellement les traitements thermiques sont choisis de façon à obtenir la fracture au niveau de la zone implantée. Selon l'invention, ces traitements sont choisis de telle façon, qu'après avoir fragilisé la zone implantée, ils entraînent l'évacuation d'au moins une partie des espèces gazeuses dans l'objectif d'obtenir une structure compatible avec la réalisation ultérieure d'étapes technologiques. Elle peut comprendre en outre l'application de contraintes à la zone fragilisée. Comme le substrat est un substrat semiconducteur, le traitement thermique de l'étape d'évacuation de tout ou partie de l'espèce gazeuse est un traitement thermique mis en oeuvre lors de la fabrication d'au moins un composant dans ladite couche mince.

Selon une variante de mise en oeuvre, le procédé comprend en outre une étape de surfragilisation de la zone fragilisée. Avant l'étape de surfragilisation, il peut être avantageux de déposer sur la couche mince une couche de rigidité, par exemple un oxyde de silicium. Cette couche de rigidité permet d'augmenter la fragilisation de la zone tout en évitant la formation de cloques. Cette couche, en fonction des composants à réaliser, est conservée ou éliminée après l'étape d'évacuation. L'étape de surfragilisation peut comprendre un traitement thermique appliqué à la zone fragilisée avant l'étape d'évacuation de l'espèce gazeuse. Elle peut comprendre aussi l'application de contraintes à la zone fragilisée. Elle peut comprendre encore l'introduction d'au moins une espèce gazeuse dans la zone fragilisée. Cette surfragilisation peut être réalisée sur l'ensemble de la zone fragilisée ou sur une ou plusieurs parties de cette zone (surfragilisation localisée).

L'introduction d'au moins une espèce gazeuse dans la zone fragilisée peut être effectuée par exemple par une méthode choisie parmi l'implantation ionique, la diffusion activée thermiquement et la diffusion plasma. L'introduction d'au moins une espèce gazeuse dans une zone du substrat, aussi bien pour la première étape du procédé que pour une étape de surfragilisation, peut être réalisée dans un substrat dont au moins la partie correspondant à ladite couche mince est en silicium, en matériau III-V, en SiC, en Ge, en GaN.

Si le substrat est un substrat semiconducteur, la surfragilisation de la zone fragilisée peut être réalisée avant la fabrication de tout ou partie d'au moins un composant par exemple à l'aide d'un traitement thermique, lors de la fabrication de tout ou partie d'au moins un composant dans ladite couche mince par exemple au moyen de recuits et/ou par l'application de contraintes, ou après par exemple en introduisant une espèce gazeuse.

Le substrat est un substrat semiconducteur et il comprend, après l'élimination de l'espèce gazeuse de la zone fragilisée, au moins une étape de fabrication de tout ou partie d'au moins un composant dans ladite couche mince. Selon un mode de réalisation de l'invention, l'étape de fabrication comprend une étape d'épitaxie ou d'hétéroépitaxie.

Le procédé peut comprendre une étape de solidarisation de la face de ladite couche mince avec un raidisseur.

L'étape de séparation peut être réalisée par application d'un traitement thermique et/ou par application de contraintes mécaniques.

La partie du substrat correspondant à ladite couche mince peut être en silicium, en matériau III-V, en SiC, en GaN.

L'étape de séparation peut être réalisée par application d'un traitement thermique et/ou par application de contraintes mécaniques.

Au moins la partie du substrat correspondant à ladite couche mince peut être en silicium, en matériau III-V, en SiC, en Ge, en GaN.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1D illustrent des étapes d'un procédé selon l'invention permettant de transférer une couche mince de matériau sur un raidisseur,
- les figures 2A à 2I illustrent des étapes d'un procédé selon l'invention permettant de transférer une couche mince de matériau comprenant des composants sur un raidisseur et permettant le report sélectif de ces composants sur des supports de réception.

### Description détaillée de modes de réalisation de l'invention

La formation de la zone fragile par introduction d'au moins une espèce gazeuse peut être réalisée par différents moyens, tels ceux divulgués par les documents FR-A-2 681 472, FR-A-2 748 851, FR-A-2 767 416 et FR-A-2 773 261 déjà cités.

L'introduction de ces espèces peut être réalisée de façon avantageuse par implantation ionique. Les espèces gazeuses sont choisies préférentiellement parmi l'hydrogène, les gaz rares ou d'autres espèces susceptibles de conduire à la présence de cavités ou "platelets" ou petites microfissures. Ces espèces peuvent être implantées seules ou en combinaison. Elles peuvent être introduites simultanément ou de façon séquentielle.

Par exemple, l'introduction des espèces gazeuses par implantation permet de former dans le substrat source des cavités situées dans la zone de clivage. Les cavités (ou micro-cavités ou "platelets" ou microbulles) peuvent se présenter sous différentes formes. Elles peuvent être sphériques et/ou aplaties avec une épaisseur pouvant varier de seulement quelques distances inter-atomiques à plusieurs nanomètres. Par ailleurs, les cavités peuvent contenir une phase gazeuse libre et/ou des atomes de gaz issus des ions implantés, fixés sur les atomes du matériau formant les parois des cavités.

Il est cependant nécessaire que les espèces introduites se trouvent dans une configuration telle qu'elles induisent la présence d'une zone fragilisée mais qu'elles ne conduisent pas à l'apparition de cloques, encore désignées par le terme anglais "blisters", en surface notamment pendant l'étape d'évacuation de l'espèce gazeuse et/ou de surfragilisation.

Dans certains cas, l'étape d'introduction des espèces gazeuses peut être réalisée de façon locale, par exemple par masquage. On peut ainsi obtenir une couche fragilisée en profondeur de façon discontinue. Cependant, si la distance entre les zones fragilisées n'est pas trop importante, il est possible au moment de la séparation d'obtenir une séparation continue sur toute la largeur du substrat. Ce masquage peut permettre par exemple de ne pas modifier sur toute la surface les propriétés du matériau par l'introduction d'espèces gazeuses. On peut ainsi garder la bonne conductibilité électrique de la zone masquée.

L'évacuation de tout ou partie des espèces gazeuses est obtenue par des traitements thermiques qui permettent aux espèces de diffuser et de quitter les cavités. Cette évacuation des espèces gazeuses peut également être assistée de contraintes appliquées de façon interne ou externe à la zone de clivage. Cette évacuation ou élimination des espèces gazeuses peut éventuellement s'accompagner d'un réarrangement cristallin qui aura pour principale conséquence de modifier la morphologie des cavités ou "platelets". Ces cavités soit seront constituées de vide, soit contiendront une faible quantité d'espèces gazeuses et permettront toujours de fragiliser le matériau. Cependant, étant donné que ces cavités ne contiennent plus de gaz ou contiennent peu de gaz, on peut réaliser plus aisément toutes sortes d'étapes technologiques même à haute température sans induire la présence de déformations de surface ou cloques.

Les conditions qui permettent d'éliminer tout ou partie des espèces gazeuses introduites dépendent de la nature même de l'espèce gazeuse (hydrogène, hélium, sous forme ionisé ou pas, sous forme moléculaire ou atomique...). Ces conditions dépendent également des conditions d'implantation (dose d'espèces introduites, profondeur de la zone de présence des cavités par rapport à la surface, budget thermique fourni au cours de l'étape d'introduction des espèces gazeuses, ...).

Dans certains cas, en particulier lors de la réalisation de tout ou partie de composant, les étapes technologiques peuvent être réalisées avantageusement de façon qu'elles participent à l'évacuation d'une partie des espèces gazeuses.

Dans certaines conditions, il peut rester des espèces gazeuses, après l'étape d'évacuation. Cependant, les espèces gazeuses restantes sont soit liées aux parois des cavités ou microfissures, soit en trop faible quantité pour induire des déformations de surface.

De façon préférentielle, il est intéressant d'augmenter la fragilisation au niveau de la zone de clivage. Ainsi, une étape de surfragilisation peut être réalisée. L'étape de surfragilisation est réalisée par application d'étapes de traitement thermique et/ou de contraintes au niveau de la zone fragilisée. Ces étapes pouvant être menées seules ou en combinaison de façon successive ou simultanée.

L'étape de surfragilisation peut comprendre une ou plusieurs étapes d'introduction de gaz ou d'espèces gazeuses telles que définies dans l'étape initiale d'introduction d'espèces gazeuses, appliquées seules ou en combinaison. Ces étapes d'introduction d'espèces gazeuses peuvent être alternées avec une ou plusieurs étapes de traitement thermique et/ou d'applications de contraintes telles que définies précédemment.

L'objectif de cette étape de surfragilisation est de faciliter l'étape consistant à séparer effectivement la couche mince du reste du substrat. De façon avantageuse, cette étape de surfragilisation peut être conduite pour permettre aux cavités de se développer et de former des cavités ou microfissures plus importantes et donc de surfragiliser le matériau.

L'étape de surfragilisation peut être réalisée de façon avantageuse en jouant sur les traitements thermiques et plus particulièrement en contrôlant les budgets thermiques. Par exemple, on peut réaliser un traitement thermique associé à une dose qui permet de fragiliser en créant des microfissures au niveau de la zone enterrée. Cependant, ces microfissures sont telles qu'elles n'induisent pas de déformation de la surface. Pour obtenir ce résultat, deux manières avantageuses peuvent être utilisées : soit on implante à relativement forte énergie par exemple à 200 keV, soit on implante à plus faible énergie et après implantation on dépose un raidisseur par exemple un oxyde de silicium. La surfragilisation peut être obtenue par exemple par le développement de cavités de dimensions relativement importantes qui peuvent être assimilées à des microfissures. Pour cela, on peut par exemple se mettre dans des conditions limites de dose d'hydrogène implanté (6.10¹⁶H⁺/cm² à 210 keV) qui permettent d'obtenir la fracture à haute température par exemple aux environs de 650°C en quelques minutes mais pas à basse température (500°C). En effet, il a été montré que de façon générale si l'on veut obtenir une fracture par traitement thermique, il faut tenir compte non seulement de la température de traitement mais aussi du temps : on parle alors de budget thermique (voir le document FR-A-2 767 416). Cependant, dans certaines conditions limites, la fracture ne peut être obtenue en dessous de certaines températures. On obtient alors des microfissures formées par exemple par interaction entre les cavités de plus petites tailles, par effet de pression dans les cavités et/ou par la présence de contraintes externes ou internes et/ou par effet d'apport des espèces gazeuses vers les cavités par exemple par diffusion. Le traitement thermique peut par exemple être réalisé durant quelques minutes à 600°C. Un tel traitement permet d'augmenter la taille des cavités ou microfissures et de surfragiliser le matériau. Cependant, si consécutivement à ce traitement, un autre traitement thermique à plus haute température est réalisé, il y a risque de détérioration de la surface (formation de "blisters", etc.). A noter qu'un traitement modifiant la contrainte peut conduire au même résultat.

Il est donc avantageux comme l'enseigne l'invention, de réaliser un recuit à plus basse température, par exemple 500°C, durant plusieurs heures de façon à évacuer tout ou partie de l'hydrogène présent dans les cavités. Ainsi, on a créé des microfissures ou des cavités de grandes dimensions, ces cavités ou microfissures ayant été totalement ou partiellement vidées de leur gaz. Ainsi, on peut recuire à haute température la structure surfragilisée sans danger pour la couche mince. Au cours de cette étape de surfragilisation les cavités peuvent voir leur forme évoluer.

Dans une variante du procédé, cette étape de surfragilisation peut être réalisée avec des conditions d'introduction d'espèces gazeuses qui conduisent à la présence de "blisters" si on recuit par exemple à 500°C. Dans ce cas, il faut adapter les conditions de traitements thermiques et/ou la présence de contraintes de façon à fragiliser le matériau sans induire la présence de "blisters" en surface. Pour cela, on peut jouer sur des temps de recuit très longs à basse température de façon à permettre aux cavités de grossir.

Dans une autre variante on peut surfragiliser des substrats avec des conditions d'introduction d'espèces gazeuses qui ne permettent pas de conduire à la présence de "blisters" après implantation ni à la séparation par traitement thermique.

De façon générale, les conditions de surfragilisation doivent être adaptées aux conditions d'introduction des espèces gazeuses. Par exemple, dans le cas d'une implantation ionique, il faut bien sûr tenir compte de la dose d'espèces implantées mais aussi de l'énergie d'implantation et de la température d'implantation. Il est également essentiel pendant l'étape de surfragilisation de prendre en compte les contraintes présentes au niveau de la zone fragilisée. Ces contraintes peuvent être appliquées à la structure de manière interne ou externe. Elles peuvent être par exemple des forces de traction, de cisaillement, de flexion, de pelage appliquées seules ou en combinaison.

De façon avantageuse, il est possible de réaliser entre l'étape de surfragilistion et l'étape de séparation tout ou partie d'un procédé de réalisation d'un composant microélectronique, optoélectronique ou même un micro-système. On peut même introduire des étapes de dépôt, de recuit, de croissance de matériaux par épitaxie en phase liquide ou en phase gazeuse. Ces étapes peuvent par exemple permettre d'adapter l'épaisseur de la couche mince. Par exemple, pour la réalisation de composants de type CMOS on peut réaliser une épitaxie d'environ 5 µm de silicium alors que pour des composants de type photovoltaïque, une épitaxie de 50 µm peut être réalisée.

Dans certains cas, cette étape de surfragilisation peut même être obtenue par tout ou partie des étapes de création du ou des composants si ces dernières étapes sont judicieusement réalisées. L'intérêt de ce procédé est qu'il est compatible avec des étapes de réalisation de composants à haute température comme par exemple 1100°C compte tenu du fait que la pression dans les cavités est fortement diminuée lors de l'étape d'évacuation de tout ou partie de l'espèce gazeuse.

Après l'étape de réalisation de tout ou partie de composants, il est possible de procéder à une étape de surfragilisation ou de fragilisation par une autre étape d'introduction de gaz, par exemple par implantation de gaz rare et/ou d'hydrogène et/ou par diffusion activée thermiquement et/ou par diffusion plasma... L'introduction de ces espèces peut se faire sur toute la surface du substrat ou de façon masquée en protégeant certaines zones ou de façon localisée en réalisant des chemins d'introduction privilégiée comme par exemple des tranchées dont la profondeur peut atteindre ou dépasser la zone fragilisée ou surfragilisée. Dans ce dernier cas, l'introduction des espèces gazeuses est obtenue de façon latérale. De façon avantageuse, cette introduction peut être contrôlée par diffusion. Cette étape peut être complétée par des étapes de traitements thermiques et/ou d'application de contraintes mécaniques. Ces étapes supplémentaires augmentent la surfragilisation et peuvent favoriser l'étape de séparation. On peut ainsi minimiser, voire supprimer les contraintes à appliquer pour obtenir la séparation.

Dans le cas où des puces sont découpées dans un substrat, il est possible de surfragiliser après découpe par introduction de gaz par les bords de la puce ou même de surdoser localement.

L'étape de séparation peut être menée par différents moyens qui peuvent être des moyens mécaniques combinés ou pas avec des moyens thermiques ou inversement. Ces moyens de séparation peuvent être appliqués de façon impulsionnelle ou continue. Des moyens de séparation à base de fluide gazeux ou liquide peuvent également être utilisés. Parmi les moyens de séparation mécanique on peut citer l'utilisation de forces de traction, de flexion, de cisaillement, de pelage, ces forces pouvant être appliquées de façon externe ou être en partie induite par les contraintes internes à la structure. Les forces externes peuvent être appliquées soit directement soit par des moyens intermédiaires tels qu'un support souple, un support rigide.

Ainsi, après séparation, la couche mince obtenue peut être autoportée ou sur un support. Dans certains cas, l'utilisation d'un support facilite la manipulation de la couche mince qui peut contenir des composants électroniques. Il peut être avantageux de solidariser, avant la séparation mais après l'étape d'élimination de tout ou partie des espèces gazeuses, le substrat éventuellement surfragilisé sur un raidisseur. Cette solidarisation peut se faire par des moyens qui permettent d'obtenir des forces très importantes ou par des moyens qui permettent d'obtenir des forces d'adhésion contrôlées et en particulier compatibles avec un décollement ultérieur au niveau de cette interface. On peut citer par exemple l'adhésion moléculaire ou la colle.

Après séparation et obtention de la couche mince, le reste du substrat peut être recyclé aussi bien en tant que substrat initial qu'en tant que support.

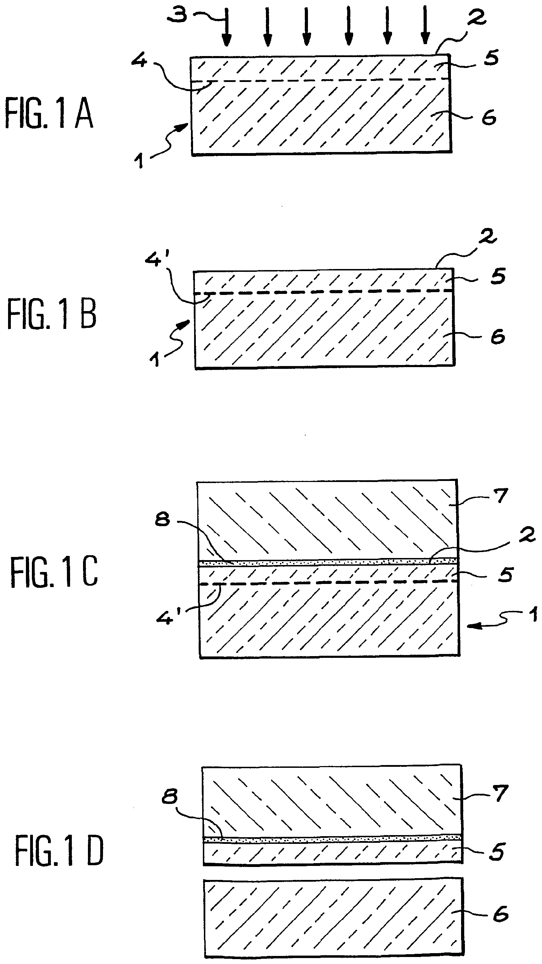

Les figures 1A à 1D illustrent un exemple de mise en oeuvre de l'invention. Ce sont des vues en coupe transversale.

La figure 1A montre un substrat en silicium 1 au cours de l'étape d'introduction d'une espèce gazeuse. Pour cela, la face 2 de ce substrat est soumise à une implantation ionique symbolisée par les flèches 3. Pour un substrat en silicium, on peut implanter de l'hydrogène pour une énergie de 200 keV et pour une dose de l'ordre de 6.10¹⁶ H⁺/cm². Il se forme alors une couche 4 de microcavités constituant une zone fragilisée. La couche 4 de microcavités ou zone fragilisée sépare le substrat 1 en deux parties : une couche mince 5, située entre la face implantée 2 et la zone fragilisée 4, et la partie restante 6 du substrat située sous la zone fragilisée 4

Un traitement thermique à une température de 600°C pendant 15 minutes permet par exemple de surfragiliser le substrat 1 au niveau de la couche 4 de microcavités qui deviennent des cavités plus grosses, voire des microfissures.

L'étape d'évacuation de tout ou partie de l'hydrogène présent dans les microcavités est réalisée en soumettant le substrat 1 à un recuit à 500°C pendant plusieurs heures, par exemple 10 heures. La figure 1B représente le substrat 1 à l'issue de cette étape. La zone surfragilisée 4' correspond à la couche 4 de microcavités mais ces microcavités sont maintenant vidées totalement ou partiellement du gaz qu'elles contenaient.

Différentes opérations technologiques impliquant une température élevée peuvent alors être réalisées. Par exemple, l'épaisseur de la couche mince 5 peut être augmentée par épitaxie en phase gazeuse.

La figure 1C illustre une étape de solidarisation de la face 2 du substrat 1 sur un substrat support 7 ou raidisseur. La solidarisation peut être obtenue par différents moyens : par une substance adhésive ou par adhésion moléculaire par exemple. Une couche de collage 8 peut aussi être utilisée. Le substrat 1 étant en silicium, une couche d'oxyde peut être formée sur la face 2 du substrat 1. Si le raidisseur 7 possède lui aussi une couche d'oxyde de silicium, la mise en contact des deux couches d'oxyde constitue alors la couche de collage.

La figure 1D illustre une étape de séparation de la couche mince 5 de la partie restante 6 du substrat le long de la zone fragilisée. On peut ainsi obtenir une structure du type silicium sur isolant (structure SOI).

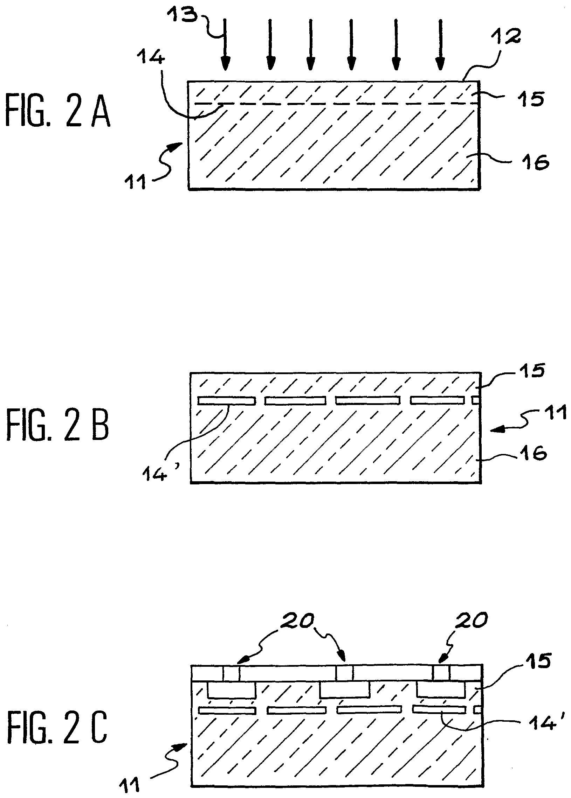

Les figures 2A à 2I illustrent un autre exemple de mise en oeuvre de l'invention. Ce sont également des vues en coupe transversale.

La figure 2A illustre l'étape d'introduction d'une espèce gazeuse effectuée comme précédemment par implantation ionique. La face 12 d'un substrat semiconducteur 11, par exemple en silicium est soumise à une implantation ionique 13 qui crée une couche de microcavités 14. On réalise ensuite éventuellement une étape de surfragilisation.

On procède ensuite, comme précédemment à l'étape d'élimination des espèces gazeuses. Le résultat obtenu est représenté à la figure 2B où la référence 14' correspond à la couche de microcavités surfragilisées, vidées partiellement ou totalement du gaz qu'elles contenaient.

La figure 2C représente le substrat 11 dont la couche mince 15 a subi un certain nombre d'opérations technologiques (épitaxie, traitements thermiques, dépôts, implantation de dopants, etc...) afin de réaliser des composants électroniques 20 dans cette couche mince.

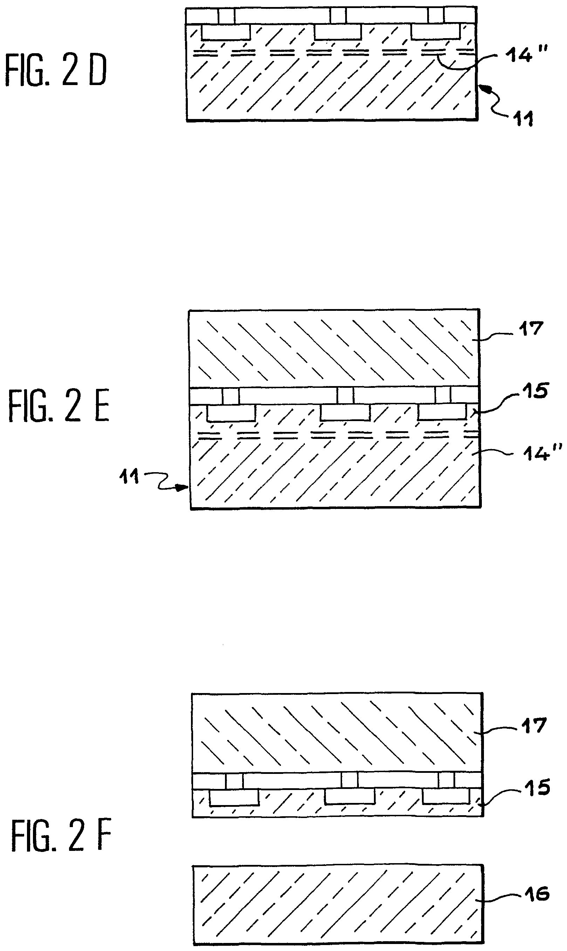

La figure 2D représente le substrat 11 qui a subi une étape supplémentaire d'introduction d'espèces gazeuses. La zone fragilisée porte maintenant la référence 14".

La figure 2E illustre la solidarisation du substrat 11 sur un substrat support 17 encore appelé raidisseur ou poignée. Si la couche mince 15 présente une certaine topologie, elle peut être planarisée avant le collage.

Les forces d'adhésion entre les deux substrats 11 et 17 peuvent être contrôlées de façon à maîtriser les forces de collage pour qu'elles soient suffisamment fortes pour permettre une séparation au niveau de la zone fragilisée, et pour que ces forces soient relativement faibles pour permettre éventuellement ensuite un décollement au niveau de l'interface de collage. Pour contrôler ces forces d'adhésion, on peut jouer sur les nettoyages et donc l'hydrophilie des surfaces, mais aussi sur la rugosité ou le pourcentage de surfaces collées.

On peut également solidariser le raidisseur par l'intermédiaire d'un adhésif qui peut permettre un collage réversible sous l'effet de traitements de type traitement thermique et/ou ultraviolet.

La figure 2F illustre l'étape de séparation de la couche mince 15 adhérant à la poignée 17 de la partie restante 16 du substrat le long de la zone fragilisée.

La poignée peut ensuite être découpée en éléments correspondant aux composants électroniques et qui peuvent être reportés sur différents supports. Ces supports peuvent être en plastique comme sur la carte à puce et dans ce cas on utilise avantageusement de la colle pour le report. Les éléments peuvent aussi être reportés sur une plaque comportant d'autres dispositifs électroniques ou optoélectroniques et dans ce cas le report peut mettre en oeuvre une technique d'adhésion moléculaire. Les éléments peuvent être reportés par des moyens classiques tels ceux dénommés "pick and place". Ensuite, en exerçant une contrainte, la couche mince collée sur son support définitif peut être séparée de sa poignée par l'intermédiaire de forces mécaniques. Selon un autre exemple d'application, ces supports sont en verre ou en substrat transparent pour réaliser notamment des imageurs.

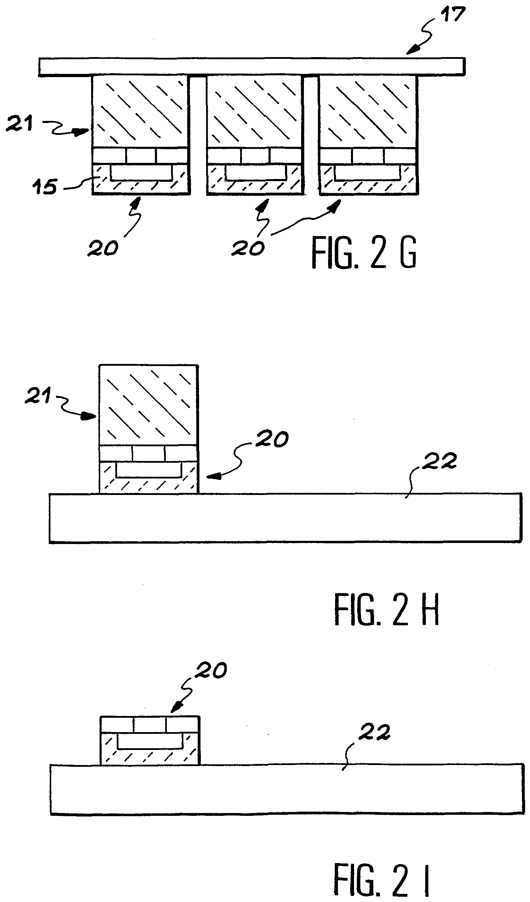

La figure 2G montre la découpe en éléments 21 de la poignée 17 supportant la couche mince 15. Les éléments 21 restent cependant encore attachés à la poignée 17.

La figure 2H montre un élément 21 reporté sur son support définitif 22.

La figure 2I montre le résultat obtenu après élimination de la partie de la poignée subsistant dans l'élément transféré. Le support définitif 22 supporte un composant 20.

L'invention peut s'appliquer à la fabrication de cellules solaires. Dans ce cas, l'objectif est de réaliser une membrane de silicium monocristallin autoportée. Pour cela, on introduit dans du silicium monocristallin des espèces gazeuses par exemple par implantation ionique. On peut utiliser des conditions d'implantation de 5,5.10¹⁶H⁺/cm² à 210 keV mais il est également possible de modifier les conditions de surfragilisation. Les traitements thermiques de surfragilisation peuvent être réalisés comme précédemment afin de développer les cavités de façon à fragiliser le matériau du substrat. Dans ce cas, le traitement thermique peut être effectué à 650°C pendant une minute. Puis, l'espèce gazeuse présente dans les microcavités est éliminée totalement ou partiellement par un traitement thermique effectué à 500°C pendant 12 heures. Une épitaxie permet d'amener la couche mince à l'épaisseur désirée, par exemple une épitaxie en phase liquide à environ 900°C avec une vitesse de croissance de l'ordre du µm/min. L'épitaxie permet d'obtenir des dopages différents du matériau de la couche mince. On peut ensuite réaliser sur la face avant de la couche mince des étapes technologiques comme par exemple la réalisation d'une couche antireflet ou d'-un plan de masse ou des zones de dopage contrôlé. Ensuite, on vient séparer la couche mince de son substrat. Par exemple, on peut utiliser des forces mécaniques ou introduire un fluide gazeux au niveau de l'interface. Ensuite, on peut reporter cette membrane sur une grande plaque de verre. De façon à obtenir une grande surface de verre recouverte de silicium monocristallin, on peut réaliser des pavages avec des plaques rondes ou carrées de façon à avoir une surface totalement recouverte. Le report peut être réalisé par l'intermédiaire de produits constituant l'adhésif ou par utilisation du collage par adhésion moléculaire. Ensuite, on peut continuer la technologie sur ses grandes surfaces de verre pour terminer la cellule. Ce pavage permet de réaliser une technologie de façon collective.

Dans une variante du procédé, la dose d'implantation peut être réduite à 6.10¹⁶H⁺/cm² pour une énergie de 200 keV. Ensuite, on réalise l'épitaxie de 50 µm de silicium à 950°C durant 50 minutes. Les montées en température sont judicieusement choisies pour permettre l'évacuation des espèces gazeuses. Par exemple, la température peut être élevée de l'ambiante à 500°C à raison de 80°C/min, puis maintenue à 500°C pendant 1 heure, ensuite être élevée à 950°C à raison de 80°C/min. Au cours de l'épitaxie, les espèces gazeuses sortent des cavités, voire du matériau, en laissant des cavités totalement ou partiellement vides qui fragilisent toujours le matériau. Dans ce cas particulier, l'étape d'élimination intègre l'étape d'épitaxie. Ces cavités sont présentes au niveau de la zone implantée. Pour séparer au niveau de la zone fragilisé, il suffit d'appliquer des efforts mécaniques sur la structure, par exemple des forces de traction et/ou de pelage et/ou de cisaillement et/ou de flexion...

Dans une autre variante du procédé, l'implantation peut être effectuée à 100 keV pour une dose de l'ordre de 5.10¹⁶H⁺/cm². Puis, un raidisseur est déposé pour éviter la formation de "blisters" au cours du traitement thermique. Ce raidisseur peut être constitué par un dépôt de 5 µm d'oxyde de silicium. Un recuit de surfragilisation est ensuite réalisé : par exemple à 550°C pendant 5 minutes, puis un recuit d'évacuation à 500°C pendant environ 12 heures. Il faut noter que le temps de recuit nécessaire pour faire grossir les cavités peut être diminué si le dépôt du raidisseur induit une contrainte importante au niveau de la zone implantée.

Selon encore une autre variante, la zone fragilisée est obtenue par co-implantation d'hydrogène et d'hélium. A noter que l'ordre d'implantation peut induire de légers changements dans les conditions de fragilisation et que la co-implantation peut permettre de diminuer la dose totale d'espèces implantées. Par exemple la co-implantation peut consister à implanter 10¹⁶ atomes d'hydrogoène/cm² à 76 keV et 10¹⁶ atomes d'hélium/cm² à 120 keV.

Dans certains cas, les traitements thermiques de surfragilisation et d'élimination peuvent être réalisés simultanément au cours d'un même traitement thermique qui peut être à une température déterminée, par exemple 530°C.

Cette invention est générique et s'applique à différents matériaux et à différentes applications. On peut citer par exemple le cas du matériau SiC sur lequel on fait une épitaxie de GaN et que l'on sépare après épitaxie pour obtenir une structure autoportée. Par exemple, on réalise une implantation ionique à 150 keV d'hydrogène pour une dose de 6.10¹⁶H⁺/cm². On fait grossir les cavités pour obtenir des microfissures à l'aide d'un traitement thermique par exemple à 950°C pendant 5 minutes. A noter que le SiC est suffisamment rigide et ne conduit pas à la formation de cloques. Ensuite on réalise un traitement thermique à 800°C pendant 12 heures pour diminuer la pression dans les cavités en éliminant du gaz. Une épitaxie de GaN est ensuite réalisée à 1050°C, à partir de laquelle on peut réaliser une couche mince avec son composant ou une couche épaisse. Puis, la séparation est réalisée, par exemple à l'aide de moyens mécaniques pour obtenir une structure autoportée ou un film en couche mince reporté sur un support.

## Revendications

1. Procédé d'obtention d'une couche mince à partir d'un substrat semiconducteur comportant les étapes suivantes :
- introduction d'au moins une espèce gazeuse (3, 13) dans une zone (4, 14) du substrat afin de former des microcavités dans cette zone, ladite zone ainsi fragilisée délimitant une couche mince (5, 15) avec une face (2, 12) du substrat,
- réalisation, après l'étape d'introduction d'au moins une espèce gazeuse, d'au moins une étape de fabrication de tout ou partie d'au moins un composant (20) dans ladite couche mince, ladite au moins une étape de fabrication étant réalisée à l'aide d'un traitement thermique,
- séparation, après ladite au moins une étape de fabrication , de la couche mince du reste du substrat,
**caractérisé en ce que** le procédé comprend en outre l'étape suivante mise en oeuvre avant ladite au moins une étape de fabrication:
- évacuation de tout ou partie de l'espèce gazeuse de la zone fragilisée, cette étape d'évacuation comprenant un traitement thermique mené de façon à permettre à tout ou partie de l'espèce gazeuse introduite de quitter les microcavités par diffusion et permettant d'éviter, lors du traitement thermique mis en oeuvre pour la réalisation de ladite au moins une étape de fabrication, un effet de pression dans les microcavités conduisant à la déformations de la surface du substrat ou à une séparation.

2. Procédé selon la revendication 1, **caractérisé en ce que** l'introduction d'au moins une espèce gazeuse est réalisée par implantation ionique.

3. Procédé selon la revendication 1, **caractérisé en ce que** l'étape d'évacuation de l'espèce gazeuse comprend en outre l'application de contraintes mécaniques à la zone fragilisée (4, 14).

4. Procédé selon l'une quelconque des revendications 1 à 3 **caractérisé en ce qu'**il comprend en outre une étape d'augmentation de la fragilisation de la zone fragilisée, dite étape de surfragilisation de la zone fragilisée, l'étape de surfragilisation comprenant l'application d'un traitement thermique à la zone fragilisée avant l'étape d'évacuation et/ou l'application de contraintes mécaniques à la zone fragilisée et/ou l'introduction d'au moins une espèce gazeuse dans la zone fragilisée.

5. Procédé selon la revendication 4, **caractérisé en ce qu'**il comprend, avant l'étape de surfragilisation, une étape de dépôt d'une couche de rigidité sur la couche mince, la couche de rigidité étant une couche d'oxyde de silicium permettant d'augmenter la fragilisation de la zone fragilisée tout en évitant la formation de cloques.

6. Procédé selon la revendication 4, **caractérisé en ce que** l'introduction d'au moins une espèce gazeuse dans la zone fragilisée est effectuée par une méthode choisie parmi l'implantation ionique, la diffusion activée thermiquement et la diffusion plasma.

7. Procédé selon la revendication 4, **caractérisé en ce que** l'étape de surfragilisation procure une surfragilisation localisée au niveau d'une ou plusieurs parties de la zone fragilisée.

8. Procédé selon la revendication 1, **caractérisé en ce que** ladite au moins une étape de fabrication comprend une épitaxie ou une hétéroépitaxie.

9. Procédé selon la revendication 1, **caractérisé en ce qu'**après la fabrication de tout ou partie du composant, le procédé comporte une étape supplémentaire d'introduction d'espèces gazeuses.

10. Procédé selon l'une quelconque des revendications 1 à 9, **caractérisé en ce qu'**il comprend une étape de solidarisation de la face (2, 12) de ladite couche mince (5, 15) avec un raidisseur (7, 17).

11. Procédé selon l'une quelconque des revendications 1 à 10, **caractérisé en ce que** l'étape d'introduction d'au moins une espèce gazeuse dans une zone du substrat est réalisée dans un substrat dont au moins la partie correspondant à ladite couche mince est en silicium, en matériau III-V, en SiC, en Ge ou en GaN .

12. Procédé d'obtention d'une couche mince selon la revendication 1, **caractérisé en ce que** l'étape de séparation est réalisée par application d'un traitement thermique et/ou par application de contraintes mécaniques.

## Patentansprüche

1. Verfahren zur Herstellung einer Dünnschicht ausgehend von einem Halbleitersubstrat, welches die folgenden Schritte umfasst:
- Einführen wenigstens einer gasförmigen Spezies (3, 13) in einen Bereich (4, 14) des Substrats, zum Bilden von Mikrohohlräumen in diesem Bereich, wobei der derart geschwächte Bereich eine Dünnschicht (5, 15) mit einer Seite des Substrats (2, 12) begrenzt,
- nach dem Schritt des Einführens wenigstens einer gasförmigen Spezies Ausführen wenigstens eines Herstellungsschrittes einer ganzen oder eines Teils wenigstens einer Komponente (20) in der Dünnschicht, wobei der wenigstens eine Herstellungsschritt mittels einer Wärmebehandlung ausgeführt wird,
- nach dem wenigstens einen Herstellungsschritt, Trennen der Dünnschicht vom restlichen Substrat,
**dadurch gekennzeichnet, dass** das Verfahren ferner den folgenden Schritt umfasst, der vor dem wenigstens einen Herstellungsschritt durchgeführt wird:
- Entfernen der gesamten oder eines Teils der gasförmigen Spezies aus dem geschwächten Bereich, wobei dieser Entfernungsschritt eine Wärmebehandlung umfasst, die so ausgeführt wird, dass die gesamte oder ein Teil der eingeführten gasförmigen Spezies die Mikrohohlräume durch Diffusion verlassen kann und so dass während der Wärmebehandlung zur Ausführung des wenigstens einen Herstellungsschrittes eine Druckwirkung in den Mikrohohlräumen vermieden werden kann, die zu einer Verformung der Oberfläche des Substrats oder zu einer Abtrennung führt.

2. Verfahren nach Anspruch 1, **dadurch gekennzeichnet, dass** die Einführung wenigstens einer gasförmigen Spezies mittels Ionenimplantation durchgeführt wird.

3. Verfahren nach Anspruch 1, **dadurch gekennzeichnet, dass** der Schritt des Entfernens der gasförmigen Spezies ferner die Ausübung mechanischer Belastungen auf den geschwächten Bereich (4, 14) umfasst.

4. Verfahren nach einem der Ansprüche 1 bis 3, **dadurch gekennzeichnet, dass** es ferner einen Schritt des Erhöhens der Schwächung des geschwächten Bereichs umfasst, der als Hyperschwächung des geschwächten Bereichs bezeichnet wird, wobei der Schritt der Hyperschwächung die Anwendung einer Wärmebehandlung in dem geschwächten Bereich vor dem Entfernungsschritt umfasst und/oder die Ausübung mechanischer Belastungen auf den geschwächten Bereich und/oder die Einführung wenigstens einer gasförmigen Spezies in den geschwächten Bereich.

5. Verfahren nach Anspruch 4, **dadurch gekennzeichnet, dass** es vor dem Schritt der Hyperschwächung einen Schritt einer Ablagerung einer Steifigkeitsschicht auf der Dünnschicht umfasst, wobei die Steifigkeitsschicht eine Siliziumoxidschicht ist, die es ermöglicht, die Schwächung des geschwächten Bereichs zu erhöhen und gleichzeitig die Bildung von Blasen zu vermeiden.

6. Verfahren nach Anspruch 4, **dadurch gekennzeichnet, dass** die Einführung wenigstens einer gasförmigen Spezies in den geschwächten Bereich durch ein Verfahren realisiert wird, das gewählt ist aus Ionenimplantation, thermisch aktivierter Diffusion und Plasmadiffusion.

7. Verfahren nach Anspruch 4, **dadurch gekennzeichnet, dass** der Schritt der Hyperschwächung zu einer Hyperschwächung im Bereich eines oder mehrerer Teile des geschwächten Bereichs führt.

8. Verfahren nach Anspruch 1, **dadurch gekennzeichnet, dass** der wenigstens eine Herstellungsschritt eine Epitaxie oder Heteroepitaxie umfasst.

9. Verfahren nach Anspruch 1, **dadurch gekennzeichnet, dass** nach der Herstellung der gesamten oder eines Teils der Komponente das Verfahren einen zusätzlichen Schritt der Einführung gasförmiger Spezies umfasst.

10. Verfahren nach einem der Ansprüche 1 bis 9, **dadurch gekennzeichnet, dass** es einen Schritt des Verbindens der Fläche (2, 12) der Dünnschicht (5, 15) mit einem Versteifungselement (7, 17) umfasst.

11. Verfahren nach einem der Ansprüche 1 bis 10, **dadurch gekennzeichnet, dass** der Schritt des Einführens wenigstens einer gasförmigen Spezies in einen Bereich des Substrats in einem Substrat ausgeführt wird, in dem wenigstens der Teil, der der Dünnschicht entspricht, aus Silizium, III-V-Material, SiC, Ge oder GaN ist.

12. Verfahren zum Erhalten einer Dünnschicht nach Anspruch 1, **dadurch gekennzeichnet, dass** der Trennschritt durch Anwenden einer Wärmebehandlung und/oder durch Ausübung mechanischer Belastungen ausgeführt wird.

## Claims

1. Process for obtaining a thin layer from a semiconductor substrate, comprising the following steps:
- introducing at least one gaseous species (3, 13) into a zone (4, 14) of the substrate in order to form micro-cavities in this zone, the zone thus weakened delimiting a thin layer with one face of the substrate;
- performing, after the step of introducing at least one gaseous species, at least one manufacturing stage of all or part of at least one component (20) in said thin layer, said at least one manufacturing stage being performed using a thermal treatment;
- separating, after said at least one manufacturing stage, the thin layer from the remaining part of the substrate,
**characterized in that** the process further comprises the following step performed before said at least one manufacturing stage:
- evacuating all or some of the gaseous species in the weakened zone, this evacuating step comprising a heat treatment carried out so as to allow all or some of the introduced gaseous species to leave the micro-cavities by diffusion and to avoid, during the thermal treatment performed during said at least one manufacturing stage, a pressure effect in the micro-cavities which could induce the surface deformation of the substrate or a separation.

2. Process according to claim 1, **characterized in that** the introduction of at least one gaseous species is done by ionic implantation.

3. Process according to claim 1, **characterized in that** the step of evacuating the gaseous species also includes application of stresses to the weakened zone.

4. Process according to any one of claims 1 to 3, **characterized in that** it further comprises a step, called over-weakening step, of increasing the weakening of the weakened zone, the over-weakening step comprising a heat treatment applied to the weakened zone before the step of evacuating and/or the application of stresses in the weakened zone and/or the introduction of at least one gaseous species in the weakened zone.

5. Process according to claim 4, **characterized in that** it comprises, before the over-weakening step, a step of depositing a stiffening layer on the thin layer, the stiffening layer being a layer of silicon oxide that increases the weakening of the weakened zone while avoiding the formation of blisters.

6. Process according to claim 4, **characterized in that** the introduction of at least one gaseous species in the weakened zone is made using a method chosen from among ionic implantation, thermally activated diffusion and plasma diffusion.

7. Process according to claim 4, **characterized in that** the over weakening step induces localized over weakening of the weakened zone at the level of one or more parts of the weakened zone.

8. Process according to claim 1, **characterized in that** said at least one manufacturing stage comprises an epitaxy or heteroepitaxy step.

9. Process according to claim 1, **characterized in that** after all or part of the component has been manufactured, the process comprises an additional step to introduce gaseous species.

10. Process according to any one of claims 1 to 9, **characterized in that** it comprises a step for solidarization of the face (2, 12) of the said thin layer (5, 15) with a stiffener (7, 17).

11. Process according to any one of claims 1 to 10, **characterized in that** the step of introducing at least one gaseous species into a zone of the substrate is done in a substrate in which at least the part corresponding to the said thin layer is made of silicon, III-V material, SiC, Ge, or GaN.

12. Process for obtaining a thin layer according to claim 1, **characterized in that** the step of separating is done by applying a heat treatment and / or by the application of mechanical stresses.
